Europäisches Patentamt

European Patent Office

Office européen des brevets

(19)

(11) EP 0 454 248 B1

(12) **FASCICULE DE BREVET EUROPEEN**

(45) Date de publication et mention
de la délivrance du brevet:
**10.01.1996 Bulletin 1996/02**

(51) Int Cl.6: **H01L 29/735**, H01L 29/08

(21) Numéro de dépôt: **91200951.1**

(22) Date de dépôt: **22.04.1991**

(54) **Circuit intégré présentant un transistor latéral multi-collecteurs**

Integrierte Schaltung bestehend aus einem Lateraltransistor mit Mehrfachkollektoren

Integrated circuit comprising a multiple collector lateral transistor

(84) Etats contractants désignés:
**DE FR GB IT NL**

(30) Priorité: **27.04.1990 FR 9005413**

(43) Date de publication de la demande:
**30.10.1991 Bulletin 1991/44**

(73) Titulaires:
- **PHILIPS COMPOSANTS**
  **F-92150 Suresnes (FR)**
  Etats contractants désignés:
  **FR**
- **Philips Electronics N.V.**
  **NL-5621 BA Eindhoven (NL)**
  Etats contractants désignés:
  **DE GB IT NL**

(72) Inventeur: **Leduc, Pierre**
**F-75008 Paris (FR)**

(74) Mandataire: **Charpail, François et al**
**F-75008 Paris (FR)**

(56) Documents cités:
**EP-A- 0 228 748       EP-A- 0 322 962**

EP 0 454 248 B1

## Description

La présente invention concerne un circuit intégré semi-conducteur présentant un transistor latéral comportant des régions d'émetteur et de collecteur d'un premier type de conductivité espacées latéralement et incluses dans une région d'un deuxième type de conductivité opposé au premier, la partie de ladite région du deuxième type située à partir de la surface de celle-ci entre les régions d'émetteur et de collecteur formant la base du transistor, le transistor latéral ayant son pourtour entouré par une couche isolante d'oxyde plus profonde que la couche de base, la région d'émetteur présentant au moins une partie allongée définissant une direction longitudinale et ayant des extrémités en regard de la couche isolante dans ladite direction longitudinale, la partie allongée étant encadrée par deux zones semi-conductrices en vis-à-vis l'une de l'autre et faisant partie de la région de collecteur, qui comprend au moins ces deux zones.

Un tel circuit intégré est connu de la demande de brevet français déposée par la demanderesse le 30 décembre 1987 sous le numéro 87 18388 (n° de publication FR 2 625 611).

Une limitation d'un tel circuit intégré est que, si on réalise un collecteur ayant plusieurs zones, le transistor ainsi obtenu présente des dispersions de fabrication en particulier en ce qui concerne le gain en courant.

La présente invention a pour objet un circuit intégré du type précité dans lequel le transistor latéral est du type multi-collecteurs et présentant un gain en courant plus stable vis à vis des dispersions de fabrication.

Ledit problème de dispersion est évité dans un transistor conforme à la revendication 1.

La demanderesse a en effet mis en évidence que ce problème de dispersion de fabrication était dû au fait que, les extrémités de la (ou des) branche(s) d'émetteur "voyant" la couche isolante profonde à travers une partie de la région du deuxième type, les courants d'injection sont modifiés au voisinage desdites extrémités d'où une dispersion des gains des transistors au cours d'une fabrication.

Il convient d'entendre, au sens de la demande par "couche isolante profonde" toute isolation qui n'est pas du type à jonction, en particulier un sillon dont les bords sont recouverts par une couche isolante.

Selon un mode de réalisation préféré, la distance entre les extrémités des parties allongées et ladite région additionnelle est supérieure à la distance entre les parties allongées et lesdites zones de collecteur. On minimise ainsi le courant qui traverse la région additionnelle. Il est également préférable que la distance moyenne entre les zones de collecteur et ladite région additionnelle soit supérieure à la distance moyenne entre les parties allongées et lesdites zones de collecteur.

Selon un mode de réalisation particulièrement avantageux, les parties allongées sont disposées en forme de croix selon une première et une deuxième direction longitudinale, et au moins quatre zones de collecteur sont disposées entre lesdites parties allongées.

L'invention sera mieux comprise à la lecture de la description qui va suivre, donnée à titre d'exemple non limitatif, en liaison avec les dessins qui représentent :

- la figure 1 une vue de dessus d'un mode préféré de réalisation de l'invention, et les figures 2a et 2b respectivement les coupes verticales XX' et YY' de la figure 1,
- la figure 3, une variante de l'invention,
- et la figure 4 une variante de la figure 2b.

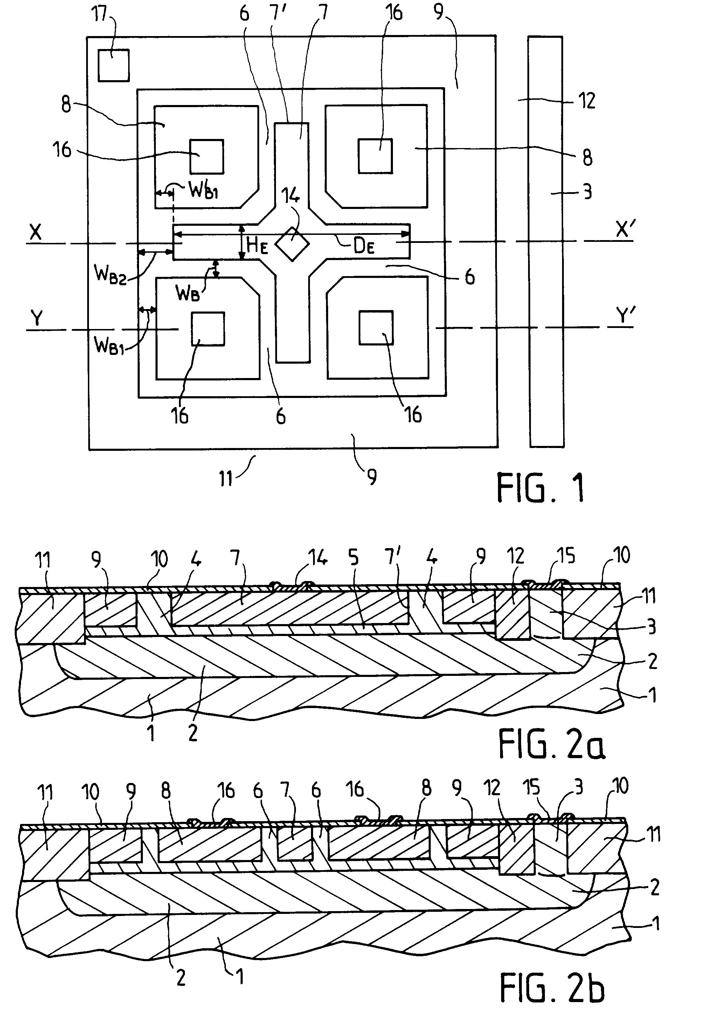

Selon les figures 1, 2a et 2b, un transistor latéral multi-collecteurs, comporte un émetteur 7 (par exemple de type p) en forme de croix présentant deux branches perpendiculaires, ce qui définit quatre secteurs dans lesquels sont disposés quatre collecteurs 8 (par exemple de type p). Entre les branches d'émetteurs et les collecteurs, une base 6 a une largeur $W_B$. Le transistor est réalisé en technologie à isolation par oxyde par exemple selon le procédé connu sous la dénomination SUBILO, et son contour, à savoir le contour délimité par l'émetteur 7 et les collecteurs 8, est entouré par une couche 11 d'oxyde profond, c'est-à-dire en l'espèce plus épais que la couche de base de manière à former un caisson d'isolation pour le transistor. Pour éviter que l'extrémité 7' des branches ne voie l'oxyde profond 11 à travers uniquement une portion de la base, ce qui selon les constatations de la demanderesse, introduit des dispersions quant aux performances (surtout gain en courant) des transistors en raison vraisemblablement des dispersions sur la qualité de l'oxyde profond 11, une région additionnelle 9 de même type de conductivité que les collecteurs 8, et constituant ce que l'on peut appeler un collecteur additionnel, est disposée entre le pourtour du transistor et la couche 11 d'oxyde profond. La région additionnelle peut avoir (mais pas nécessairement) le même dopage que les régions de collecteur 8 (par exemple $10^{19}/cm^3$ ou une résistance de 500Ω par carré selon le procédé SUBILO précité). En dessous de l'ensemble, est disposée une couche enterrée 2 très dopée par exemple $n^+$ en continuité électrique avec une couche 3 de même type également très dopée et s'étendant depuis une surface principale du circuit intégré jusqu'à la couche enterrée. La couche 3 remplit la fonction de prise de contact de base. On désigne par 12 la portion de l'oxyde profond 11 séparant la couche 3 de la région additionnelle 9. Comme montré plus particulièrement aux figures 2a et 2b, la couche enterrée 2 est disposée sous le pourtour (tel que défini ci-dessus) du transistor ainsi que sous la couche 3 et au-delà de manière que sa jonction avec le substrat par exemple de type p se termine à l'oxyde profond 11.

Une couche d'oxyde mince 10 est disposée sur la surface principale du circuit intégré et présente des fenêtres à travers lesquelles des bandes de contact 14 pour l'émetteur, 15 pour la base et 16 pour le collecteur sont en contact électrique avec ces zones respectives.

En se reportant de nouveau à la figure 1, nous allons maintenant calculer le courant prélevé par la région additionnelle. Celle-ci peut être considéré soit uniquement dans sa fonction recherchée de séparation de l'oxyde profond des extrémités des branches d'émetteur, auquel cas on cherchera à minimiser le courant qu'elle consomme, soit également comme collecteur supplémentaire auquel cas on cherchera à lui donner le gain désiré pour cette application.

Pour les calculs, on suppose que le transistor est polarisé en régime amplificateur, la région émetteur-base étant polarisée en direct et les jonctions collecteur-base en inverse.

Soit $I_C$ le courant supposé identique dans chacune des régions de collecteur, et

I' le courant dans la région additionnelle en regard d'une extrémité d'emetteur.

Soit $\beta_i$ le gain en courant en émetteur commun pour l'une quelconque des régions de collecteur, et

$\beta'$ le gain en courant correspondant à la région additionnelle en regard d'une extrémité d'émetteur et formant un transistor latéral (pnp) parasite.

Soit $I_{BT}$ le courant de base total.

Soit $D_E$ la longueur totale d'une branche d'émetteur (plus grande dimension d'une région d'émetteur), et $H_E$ sa largeur.

Soit $W_B$ la distance entre une branche d'émetteur et une région de collecteur (dans le cas où cette distance n'est pas constante, $W_B$ est la distance moyenne).

Soit $w_{B1}$ la distance (ou la distance moyenne) entre une région de collecteur et la région additionnelle.

Soit $W_{B2}$ la distance entre l'extrémité d'une branche d'émetteur et la région additionnelle.

Soit enfin $W'_{B1}$ l'écart, mesuré dans la direction longitudinale d'une branche d'émetteur, entre une extrémité d'une dite branche et un bord extrême d'une région de collecteur ($WB_2 = W_{B1} + W'_{B1}$).

On suppose, pour un premier mode de calcul, que la région additionnelle est portée à un potentiel inférieur à celui de la base.

On a :

$$\beta_i = \frac{Ic}{I_{BT}} \text{ et } \beta' = \frac{I'}{I_{BT}}$$

On a en première approximation :

$$I_c = hJ_sD_E \left(\exp\frac{V_{BE}}{V_T} - 1\right)$$

avec exp = exponentielle

La longueur d'émetteur en face d'une région de collecteur est en effet égale environ à

$$2 \, x \, \frac{D_E}{2}$$

h = constante (facteur de forme).

avec $J_S$ = densité d'injection latérale dans l'émetteur, par unité de longueur.

$V_{BE}$ = tension base-émetteur ; $V_T$ = 26mV

$$I' = h' \frac{W_B}{W_{B2}} H_E J_s \left(\exp\frac{V_{BE}}{V_T} - 1\right)$$

h' = constante (facteur de forme lié à la région additionnelle).

On a alors :

$$\frac{I'}{I_c} = \frac{\beta'}{\beta_i} = \frac{h'}{h} \frac{W_B}{W_{B2}} \frac{H_E}{D_E}$$

Exemple : $D_E = 45\mu m$ $H_E = 2\mu m$ $W_B = 2,5\mu m$ $W_{B2} = 5\mu m$. avec $h' \simeq h$ (approximation vérifiée en pratique) ; alors $I' = 2,2 \, 10^{-2}Ic$, et le courant dans la région additionnelle 9 est très faible en comparaison des courants dans les régions de collecteur 8.

On suppose, pour un deuxième mode de calcul, que la région additionnelle est réunie à la base du transistor.

La valeur du gain $\beta_i$ diminue et devient

$$\beta'_i = \frac{I_c}{I_{BT} + 4I'}$$

car le courant I' correspondant à chacune des extrémités d'émetteur participe dans ce cas au courant de base.

d'où

$$\beta'_i = \frac{\beta_i}{1 + 4\beta'}$$

Exemples : avec les mêmes valeurs que précédemment et

$\beta_i = 10$, on a :

$\beta'_i \simeq 5,3$

avec les mêmes valeurs que précédemment et $\beta_i = 5$, on a $\beta'_i = 3,5$

En connectant la région additionnelle à la base, on peut éviter la polarisation d'une connexion supplémentaire (pour la région additionnelle), mais au prix toutefois d'un sacrifice important sur le gain en courant On a intérêt dans ce cas à augmenter $W_{B2}$. Par exemple si au lieu de $W_{B2} = 10\mu$, on prend $W_{B2} = 5\mu$, alors, si $\beta_i = 10$, $\beta' = 6,9$.

Un transistor tel que décrit ci-dessus peut être avantageusement réalisé comme un transistor à gain élevé tel que décrit dans la demande française FR 2.625.611 précitée. La région d'émetteur présente une profondeur et un niveau de dopage tels que la longueur de diffusion des porteurs minoritaires injectés verticalement dans celle-ci est supérieure ou égale à l'épaisseur de celle-ci. Une liaison électrique d'émetteur (14) présente au moins une zone en contact électrique à travers au moins une fenêtre d'une couche isolante (10), le rapport entre la surface totale de ladite région d'émetteur et celle de ladite zone (14) étant au moins égal à 20, et le rapport entre la plus grande dimension longitudinale (la longueur

$D_E$ sur la figure 1) et la plus grande dimension transversale (largeur $H_E$ sur la figure 1) d'au moins une partie allongée ou branche étant au moins égale à 5. On rappelera que les branches peuvent avoir une forme de losange et que plusieurs zones (14) peuvent être réparties pour former contact. Dans ce cas il faut bien sûr additionner les surfaces des zones individuelles (14) pour obtenir la surface totale à prendre en compte.

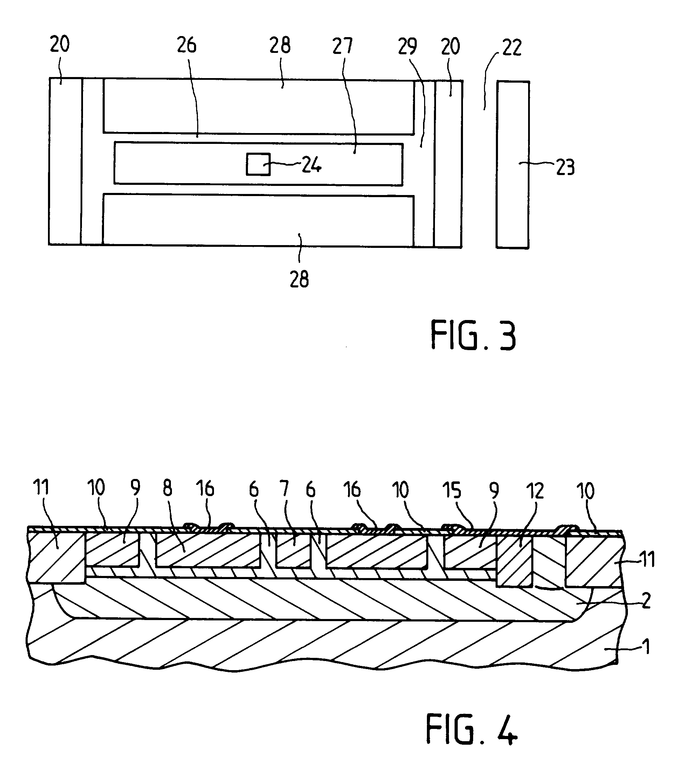

Selon la figure 3, la région d'émetteur comporte une région allongée 27 de part et d'autre de laquelle sont disposées deux régions de collecteur 28. La région additionnelle est en deux parties 20 situées en regard des extrémités de la région 27. L'expression "en regard des extrémités" concerne aussi bien la dimension des parties 20 transversalement que verticalement par rapport aux extrémités. Autrement dit, une région 20 a une longueur au moins égale à la largeur de la région 27 au niveau de son extrémité et une profondeur au moins égale à celle de la région 27 à ce même niveau. Les deux régions 20 peuvent être interconnectées.

Selon la figure 4, on a représenté une liaison électrique 15 (par exemple couche de métallisation) interconnectant électriquement la région additionnelle 9 et la base (au niveau de la prise de contact 3).

## Revendications

1. Circuit intégré semi-conducteur présentant un transistor latéral comportant des régions d'émetteur et de collecteur d'un premier type de conductivité espacées latéralement et incluses dans une région d'un deuxième type de conductivité opposé au premier, la partie de ladite région du deuxième type située à partir de la surface de celle-ci entre les régions d'émetteur et de collecteur formant la base du transistor, le transistor latéral ayant son pourtour entouré par une couche isolante d'oxyde plus profonde que la couche de base, la région d'émetteur présentant au moins une partie allongée (7) définissant une direction longitudinale et ayant des extrémités en regard de la couche isolante dans ladite direction longitudinale, la partie allongée (7) étant encadrée par deux zones semi-conductrices (8) en vis-à-vis l'une de l'autre et faisant partie de la région de collecteur, qui comprend au moins ces deux zones (8), caractérisé en ce qu'une région additionnelle (9) du premier type de conductivité est disposée entre le pourtour du transistor et la couche isolante (12) au moins en regard desdites extrémités de ladite partie allongée de la région d'émetteur.

2. Circuit intégré selon la revendication 1, caractérisé en ce que la distance ($W_{B2}$) entre les extrémités (7') des parties allongées et ladite région additionnelle (9) est supérieure à la distance moyenne ($W_B$) entre les parties allongées (7) et lesdites zones de collecteur (8).

3. Circuit intégré selon une des revendications 1 ou 2, caractérisé en ce que la région additionnelle (9) borde la totalité du pourtour du transistor.

4. Circuit intégré selon la revendication 3 caractérisé en ce que la distance moyenne ($W_{B1}$) entre les zones de collecteur (8) et ladite région additionnelle (9) est supérieure à la distance moyenne ($W_B$) entre les parties allongées (7) et lesdites zones de collecteur (8).

5. Circuit intégré selon une des revendications 1 à 4 caractérisé en ce que les parties allongées (7) sont au nombre de deux, disposées en forme de croix selon une première et une deuxième directions longitudinales et formant la région d'émetteur, et en ce que la région de collecteur comporte au moins quatre zones (8) disposées entre lesdites parties allongées (7).

6. Circuit intégré selon une des revendications précédentes caractérisé en ce que la région d'émetteur présente une profondeur et un niveau de dopage tels que la longueur de diffusion des porteurs minoritaires injectés verticalement dans celle-ci est supérieure ou égale à l'épaisseur de ladite région d'émetteur.

7. Circuit intégré selon la revendication 6 caractérisé en ce qu'il comporte au moins une liaison électrique d'émetteur présentant au moins une zone (14) en contact électrique à travers au moins une fenêtre d'une couche siolante (10), le rapport entre la surface totale de ladite région d'émetteur (7) et celle de ladite zone (14) de liaison électrique d'émetteur étant au moins égale à 20, et le rapport entre la plus grande dimension longitudinale ($D_E$) et la plus grande dimension transversale ($H_E$) d'au moins une desdites parties allongées (7) étant au moins égale à 5.

## Patentansprüche

1. Integrierter Halbleiterschalter mit einem Lateraltransistor mit Emitter- und Kollektorgebieten von einem ersten Leitfähigkeitstyp, die lateral voneinander getrennt und in einem Gebiet von einem zweiten Leitfähigkeitstyp gegenüber dem ersten aufgenommen sind, wobei der Anteil des Gebiets vom zweiten Typ von der Oberfläche dieses Gebiets sich zwischen den Emitter- und Kollektorgebieten befindet und die Basis des Transistors bildet, der Lateraltransistor an seinem Umfang von einer tieferen Isolier-Oxidschicht als die Basisschicht umgeben ist, das Emittergebiet wenigstens einen verlängerten Anteil (7) zur Definition einer Längsrichtung aufweist und gegenüber der Isolierschicht in der Längsrichtung Ausläufer hat, der verlängerte Anteil (7) von zwei Halbleiterzonen (8) einander gegenüber eingerahmt sind und einen Teil des Kollektorgebiets darstellt, das wenigstens diese zwei Zonen (8) enthält, dadurch gekennzeichnet, daß ein Zusatzgebiet (9) vom ersten Leitfähigkeitstyp sich zwischen dem Umfang des Transistors und der Isolierschicht (12) wenigstens gegenüber diesen Ausläufern des verlängerten Anteils des Emittergebiets angeordnet ist.

2. Integrierte Schaltung nach Anspruch 1, dadurch gekennzeichnet, daß der Abstand ($W_{B2}$) zwischen den Ausläufern (7') der verlängerten Anteile und dem Zusatzgebiet (9) größer ist als der mittlere Abstand ($W_B$) zwischen den verlängerten Anteilen (7) und den Kollektorzonen (8).

3. Integrierte Schaltung nach einem der Ansprüche 1 oder 2, dadurch gekennzeichnet, daß das Zusatzgebiet (9) den gesamten Umkreis des Transistors begrenzt.

4. Integrierte Schaltung nach Anspruch 3, dadurch gekennzeichnet, daß der mittlere Abstand ($W_{B1}$) zwischen den Kollektorzonen (8) und dem Zusatzgebiet (9) größer ist als der mittlere Abstand ($W_B$) zwischen den verlängerten Anteilen (7) und den Kollektorzonen (8).

5. Integrierte Schaltung nach einem der Ansprüche 1 bis 4, dadurch gekennzeichnet, daß die verlängerten Anteile (7) eine Anzahl von zwei in Kreuzform nach einer ersten und einer zweiten Längsrichtung betragen und das Emittergebiet bilden, und daß das Kollektorgebiet wenigstens vier Zonen (8) zwischen den verlängerten Anteilen (7) enthält.

6. Integrierte Schaltung nach einem der vorangehenden Ansprüche, dadurch gekennzeichnet, daß das Emittergebiet eine Tiefe und einen Dotierungspegel derart aufweist, daß die Diffusionslänge der darin vertikal injizierten Minoritätsträger höher oder gleich der Dicke des Emittergebiets beträgt.

7. Integrierte Schaltung nach Anspruch 6, dadurch gekennzeichnet, daß sie wenigstens eine elektrische Emitterverbindung mit mindestens einer Zone (14) mit elektrischem Kontakt durch wenigstens ein Fenster einer Isolierschicht (10) enthält, wobei das Verhältnis zwischen der Gesamtfläche des Emittergebiets (7) und der dieser Zone (14) der elektrischen Emitterverbindung wenigstens gleich 20 ist, und das Verhältnis zwischen der größeren Längsabmessung ($D_E$) und der größeren Querabmessung ($H_E$) wenigstens eines der verlängerten Anteile (7) wenigstens gleich 5 ist.

## Claims

1. An integrated semiconductor circuit comprising a lateral transistor having emitter and collector regions of a first conductivity type, spaced apart laterally, and included in a region of a second conductivity type opposed to the first, the portion of said region of the second conductivity type extending from the surface thereof between the emitter and collector regions forming the base of the transistor, which lateral transistor has its circumference surrounded by an insulating layer of oxide which is deeper than the base layer, while the emitter region has at least one elongate portion (7) which defines a longitudinal direction, which has ends opposite the insulating layer in said longitudinal direction, and which elongate portion (7) is flanked by two semiconductor zones (8) facing one another and forming part of the collector region, which comprises at least these two zones (8), characterized in that an additional region (9) of the first conductivity type is disposed between the circumference of the transistor and the insulating layer (12) at least opposite said ends of said elongate portion of the emitter region.

2. An integrated circuit as claimed in Claim 1, characterized in that the distance ($W_{B2}$) between the ends (7') of the elongate portions and said additional region (9) is greater than the distance ($W_B$) between the elongate portions (7) and said collector zones (8).

3. An integrated circuit as claimed in any one of the Claims 1 and 2, characterized in that the additional region (9) borders on the entire contour of the transistor.

4. An integrated circuit as claimed in Claim 3, characterized in that the average distance ($W_{B1}$) between the collector zones (8) and said additional region (9) is greater than the average distance ($W_B$) between the elongate portions (7) and said collector zones (8).

5. An integrated circuit as claimed in any one of the Claims 1 to 4, characterized in that there are two elongate portions arranged in the shape of a cross in a first and a second longitudinal direction and forming the emitter region, and in that the collector region comprises at least four zones (8) disposed between said elongate portions (7).

6. An integrated circuit as claimed in any one of the preceding Claims, characterized in that the emitter region has a depth and a doping level such that the diffusion length of the minority carriers injected vertically therein is higher than or equal to the thickness of said emitter region.

7. An integrated circuit as claimed in Claim 6, characterized in that it comprises at least an electrical emitter connection having at least one zone (14) in electrical contact through at least one window of an insulating layer (10), the ratio of the total surface area of said emitter region (7) to that of said electrical emitter connection zone (14) being at least 20, and the ratio of the greatest longitudinal dimension ($D_E$) to the greatest transversal dimension ($H_E$) of at least one of said elongate portions (7) being at least equal to 5.

EP 0 454 248 B1

FIG. 1

FIG. 2a

FIG. 2b

EP 0 454 248 B1

FIG. 3

FIG. 4